# EUROPEAN PATENT APPLICATION

(11) **EP 2 348 514 A1**
(43) Date of publication of application: **27.07.2011**
(21) Application number: 09827559.7
(22) Date of filing: 18.11.2009
(51) Int. Cl.: H01B 13/00, G03F 7/40, G03F 7/42, H01B 5/14, H05K 1/09, H05K 3/06

(54) **METHOD FOR PRODUCING SUBSTRATE HAVING PATTERNED CONDUCTIVE POLYMER FILM AND SUBSTRATE HAVING PATTERNED CONDUCTIVE POLYMER FILM**

(30) Priority: 19.11.2008 JP 2008295018
(71) Applicant: Toagosei Co., Ltd, Minato-ku, Tokyo 105-8419 (JP); Tsurumi Soda Co, Ltd., Tsurumi-ku Yokohama-shi Kanagawa 230-0045 (JP)
(72) Inventor: IHARA Takashi, Nagoya-shi Aichi 455-0026 (JP)
(74) Representative: Wilhelms · Kilian & Partner Patentanwälte
(86) International application number: PCT/JP2009/069524
(87) International publication number: WO 2010/058778

(57) **Abstract**

A process for producing a substrate having a patterned conductive polymer film is provided in which stripping properties are excellent, and discoloration of an end part of the conductive polymer film when a resist film is stripped from the conductive polymer film is suppressed. The process for producing a substrate having a patterned conductive polymer film includes in sequence a step of forming a substrate having in order above the substrate a conductive polymer film and a patterned resist film, a step of etching the conductive polymer film in accordance with the resist film pattern, and a step of stripping the resist film above the conductive polymer film by means of a stripping liquid, the stripping liquid containing an organic solvent (A) at 5 to 40 wt % selected from the group consisting of an *N*-alkylpyrrolidone, a carboxylic acid amide compound, a dialkyl sulfoxide, and an ether compound and an organic solvent (B) at 60 to 95 wt % selected from the group consisting of an alkyrolactone, an alkylene carbonate, and a polyhydric alcohol.

## Description

### Technical Field

The present invention relates to a process for producing a substrate having a patterned conductive polymer film and to a substrate having a patterned conductive polymer film.

### Background Art

In recent years, as a transparent conductive film, inorganic compounds containing ITO (indium tin oxide) or ZnO (zinc oxide) as a component have been used, but since indium is a rare element and inorganic compounds are difficult to process, research into conductive polymers as alternatives has been carried out.

These conductive polymers not only have excellent conductivity, optical transmission, and luminescence, but also have excellent film forming properties, thin film properties, and flexibility, and development of the application thereof to electrolytic capacitors, antistatic films, polymer EL, and solar cells has been carried out.

For examples, in the case of electrolytic capacitors, the use of a conductive polymer having higher conductivity than that of an electrolyte enables an electrolytic capacitor to be formed that is chemically and physically stable and has excellent heat resistance, and good frequency characteristics.

Furthermore, since static electricity can be prevented while maintaining transparency by forming a thin film of a conductive polymer on the surface of a polymer film, it can be used as an antistatic film or an antistatic container having good ease of use.

When a conductive polymer is used as an alternative to ITO film for the transparent conductive film, it is necessary to employ a patterning method that is practical, useful, and highly productive, and various types of patterning methods have been examines.

For example, patterning by an inkjet printing method is known (Patent Document 1).

On the other hand, a method in which a conductive polymer formed as a film on a substrate is coated with a photoresist, a pattern is formed in the resist film using photolithography, and the conductive polymers as a lower layer is then etched in accordance with the pattern using an etching agent via the resist film as a mask material has the advantage that a pattern having a high aspect ratio can be formed with good precision.

A method for patterning a conductive polymers by etching is disclosed in, for example, Patent Document 2.

For stripping a resist film, an organic solvent having excellent dissolving power is used. Examples thereof includes *N,N*-dimethylformamide (Patent Document 3), dimethyl sulfoxide (Patent Document 4), and tetrahydrofuran (Patent Document 5).
[Patent Document 1] JP-A-2005-109435 (JP-A denotes a Japanese unexamined patent application publication)
[Patent Document 2] JP-A-5-335718
[Patent Document 3] JP-A-01-081949
[Patent Document 4] JP-A-60-066424
[Patent Document 5] JP-A-2003-346575

### Disclosure of Intention

### Problems to be Solved by the Invention

The method described in Patent Document 1 is a simple method with good precision since patterning is carried out by printing, but there is the defect that it is difficult to make an ink using a conductive polymer.

The method described in Patent Document 2 requires stripping of a resist film as an upper layer by an organic solvent after a conductive polymer, is etched. In this case, since both the resist film and the conductive polymer film are organic polymers, it is necessary to employ a solvent that causes stripping only at the interface between the resist film and the conductive polymer film, does not cause stripping at the interface between the conductive polymer film and the substrate, and does not invade the conductive polymer and, moreover, since an edge part of the conductive polymer film that comes into contact with an etching liquid is easily invaded by an organic solvent, there are particularly difficult technical problems.

With regard to stripping agents described in Patent Documents 3 to 5, these organic solvents not only strip a photoresist but also penetrate a patterned conductive polymer. They penetrate via an edge part in particular of a patterned conductive polymer, thus causing the problems that the penetrated portion is discolored, the film thickness increases due to swelling, or the pattern comes off.

Such discoloration of a conductive polymer greatly degrades its function as a transparent conductive films. For example, when it is applied to various types of displays employing a transparent conductive film, such as an LCD, a PDP, an EL display, and a touch panel, the shadow of the conductive polymer pattern appears on a screen displaying an image, thus causing a serious problem in display of the image.

It is an object of the present invention to solve the above-mentioned problems, and specifically to provide a process for producing a substrate having a patterned conductive polymer film that has excellent stripping properties and can suppress discoloration of an edge part of the conductive polymer film when stripping a resist film from the conductive polymer film, and a substrate obtained by the production process.

### Means for Solving the Problems

As a result of an intensive investigation by the present inventors, it has been found that the above-mentioned problems can be solved by means described in <1> and <9> below, and the present invention has thus been accomplished. They are described below together with <2> to <8>, which are preferred embodiments.
<1> A process for producing a substrate having a patterned conductive polymer film, comprising in sequence a step of forming a substrate having in order above the substrate a conductive polymer film and a patterned resist film, a step of etching the conductive polymer film in accordance with the resist film patter, and a step of stripping the resist film above the conductive polymer film by means of a stripping liquid, the stripping liquid comprising an organic solvent (A) and an organic solvent (B), the organic solvent (A) being selected from the group consisting of an *N*-alkylpyrrolidone, a carboxylic acid amide compound, a dialkyl sulfoxide, and an ether compound, the organic solvent (B) being selected from the group consisting of an alkyrolactone, an alkylene carbonate, and a polyhydric alcohol, the organic solvent (A) having a content of at least 5 wt % but no greater than 40 wt % of the stripping liquid, and the organic solvent (B) having a content of at least 60 wt % but no greater than 95 wt % of the stripping liquid,
<2> the process for producing a substrate according to <1>, wherein the organic solvent (A) is selected from the group consisting of *N-*methylpyrrolidone, *N,N*-dimethylformamide, *N,N*-dimethylacetamide, diethylene glycol monomethyl ether, and tetrahydrofuran,
<3> the process for producing a substrate according to <1> or <2>, wherein the organic solvent (B) is y-butyrolactone,
<4> the process for producing a substrate according to any one of <1> to <3>, wherein when the width of penetration of the organic solvent (A) on its own into the conductive polymers film is defined as a, the width of penetration of the stripping liquid into the conductive polymer film is no greater than a/2,
<5> the process for producing a substrate according to any one of <1> to <4>, wherein the conductive polymer is selected from the group consisting of polypyrrole, polyaniline, polythiophene, and derivatives thereof,
<6> the process for producing a substrate according to any one of <1> to <5>, wherein the conductive polymer is a poly(3,4-dialkoxythiophene) or a derivative thereof,
<7> the process for producing a substrate according to any one of <1> to <6>, wherein the conductive polymer is a poly(3,4-dialkoxythiophene),
<8> the process for producing a substrate according to any one of <1> to <7>, wherein the substrate is selected from the group consisting of a glass, a wafer, a polyester, and a polyolefin, and
<9> a substrate comprising a patterned conductive polymers film obtained by the process according to any one of <1> to <8>.

### Effect of the Intention

In accordance with the present invention, there can be provided a process for producing a substrate having a patterned conductive polymer film that has excellent stripping properties and can suppress discoloration of an edge part of the conductive polymer film when stripping a resist film from the conductive polymer films, and a substrate obtained by the production process.

### Brief Description of Drawings

FIG. 1A process drawing showing a method for stripping a resist film formed directly on a conductive polymer.
FIG. 2 A process drawing showing a method for stripping a resist film formed on a conductive polymer via another film,

### Explanation of Reference Numerals and Symbols

- 10: Conductive polymer
- 20: Substrate
- 30: Resist film
- 40: Mask pattern
- 50: Another film

### Best Mode for Carrying Out the Invention

The process for producing a substrate having a patterned conductive polymer film of the present invention comprises in sequence a step of forming a substrate having in order above the substrate a conductive polymer film and a patterned resist film, a step of etching the conductive polymer film in accordance with the resist film pattern, and a step of stripping the resist film above the conductive polymer film by means of a stripping liquid, the stripping liquid comprising an organic solvent (A) and an organic solvent (B), the organic solvent (A) being selected from the group consisting of an *N-*alkylpyrrolidone, a carboxylic acid amide compound, a dialkyl sulfoxide, and an ether compound, the organic solvent (B) being selected from the group consisting of an alkyrolactone, an alkylene carbonate, and a polyhydric alcohol, the organic solvent (A) having a content of at least 5 wt % but no greater than 40 wt % of the stripping liquid, and the organic solvent (B) having a content of at least 60 wt % but no greater than 95 wt % of the stripping liquid.

In the present invention, in accordance with the use, as a stripping liquid for a resist film formed above a conductive polymer film, of a mixed liquid of an organic solvent (A) having excellent stripping properties for the resist film and an organic solvent (B) having little penetration into the conductive polymer, the stripping properties for the resist film are excellent, and discoloration of the conductive polymer film provided as a layer below the resist film is suppressed.

In the present invention, the notation lower limit to upper limit', which expresses a numerical range, means 'at least the lower limit but no greater than the upper limit' unless otherwise specified, and the notation 'upper limit to lower limit' means 'no greater than the upper limit but at least the lower limit' unless otherwise specified. That is, they mean numerical ranges that include the upper limit and the lower limit, which are end points.

### 1. Stripping liquid, conductive polymer, substrate, resist film, and conductive polymer film pattern (patterned conductive polymer film)

### (Stripping liquid)

In the present invention, the stripping liquid for the resist film contains the organic solvent (A) and the organic solvent (B). This stripping liquid strips only the resist film from the interface between the conductive polymer film and the resist film.

The stripping liquid may contain another organic solvent other than the organic solvent (A) and the organic solvent (B), another inorganic solvent such as water, and another component such as a surfactant; the total content of the organic solvent (A) and the organic solvent (B) is preferably at least 70 wt % of the entire stripping liquid, more preferably at least 80 wt %, and yet more preferably at least 90 wt %. It is particularly preferable that only the organic solvent (A) and the organic solvent (B) are contained as solvents.

### <organic solvent (A)>

The organic solvent (A) is selected from the group consisting of an *N-*alkylpyrrolidone, a carboxylic acid amide compound (monoacylamine compound), a dialkyl sulfoxide, and an ether compound. With regard to the organic solvent (A), one type thereof may be used on its own or two or more types thereof may be used in combination.

The *N*-alkylpyrrolidone is a cyclic amide compound, and in the present invention the amide means a compound formed by dehydration-condensation of a carboxylic acid and any of ammonia, a primary amine, and a secondary amine. With regard to the *N*-alkylpyrrolidone, the number of carbon atoms of the alkyl group is preferably 1 to 4; examples thereof include *N-*methylpyrrolidone and *N*-ethylpyrrolidone, and *N*-methylpyrrolidone is particularly preferable.

The carboxylic acid amide compound is an open-chain amide compound, and this carboxylic acid amide compound means a compound formed by dehydration-condensation of a carboxylic acid and any of ammonia, a primary amine, and a secondary amine. Examples of the carboxylic acid amide compound include a carboxylic acid amide (R¹CO-NH₂), an *N-*alkylcarboxylic acid amide (R¹CO-NHR²), and an *N,N*-dialkylcarboxylic acid amide (R¹CO-NR²R³), and among them an *N,N*-dialkylcarboxylic acid amide is preferable. Here, R¹ above denotes a hydrogen atom or a monovalent organic group; it is preferably a hydrogen atom or an alkyl group having 1 to 4 carbon atoms, and more preferably a hydrogen atom or a methyl group. R² and R³ independently denote an alkyl group, and are preferably an alkyl group having '1 to 4 carbon atoms, more preferably a methyl group or an ethyl group, and yet more preferably a methyl group. Examples of the carboxylic acid amide compound include formamide, *N*-methylformamide, *N-*methylacetamide, *N,N*-dimethylformamide, and *N,N*-dimethylacetamide, and *N,N*-dimethylformamide and *N,N*-dimethylacetamide are preferable.

The dialkyl sulfoxide (R⁴-SO-R⁵) is a compound in which two alkyl groups are bonded to the sulfur atom of a sulfinyl group. R⁴ and R⁵ above are alkyl groups, preferably alkyl groups having 1 to 4 carbon atoms, more preferably methyl groups or ethyl groups, and yet more preferable methyl groups. Examples of the dialkyl sulfoxide include dimethyl sulfoxide.

The ether compound means a compound having an ether bond (-O-), and it may be either a cyclic ether compound or an open-chain ether compound. Specific examples of the ether compound include oxetane, tetrahydrofuran, tetrahydropyran, ethylene glycol monomethyl ether, ethylene glycol monoethyl ether, ethylene glycol diethyl ether, ethylene glycol monobutyl ether, diethylene glycol monoethyl ether, Diethylene glycol dimethyl ether, diethylene glycol monoethyl ether, diethylene glycol diethyl ether, diethylene glycol monobutyl ether, triethylene glycol monomethyl other, triethylene glycol dimethyl ether, triethylene glycol monoethyl ether, triethylene glycol diethyl ether, triethylene glycol monobutyl ether, propylene glycol monomethyl ether, propylene glycol dimethyl ether, propylene glycol monoethyl ether, propylene glycol diethyl ether, dipropylene glycol monomethyl ether, dipropylene glycol dimethyl ether, dipropylene glycol monoethyl ether, and dipropylene glycol diethyl ether. The ether compound is preferably one having high affinity with water since it can be washed away by water. From such a viewpoint, tetrahydrofuran, diethylene glycol, monomethyl ether, diethylene glycol monoethyl ether, diethylene glycol diethyl ether, diethylene glycol monobutyl ether, triethylene glycol monomethyl ether, triethylene glycol dimethyl ether, triethylene glycol monoethyl ether, triethylene glycol monobutyl ether, and dipropylene glycol monomethyl ether are preferable.

As such an organic solvent (A), *N*-methylpyrrolidone, *N,N-*dimethylformamide, *N,N*-dimethylacetamide, diethylene glycol monoethyl ether, and tetrahydrofuran are particularly preferable, and *N-*methylpyrrolidone, *N,N*-dimethylformamide, diethylene glycol monoethyl ether, and tetrahydrofuran are more preferable.

### <Organic solvent (B)>

In the present invention, the organic solvent (B) is an organic solvent having little penetration into a conductive polymer. Mixing the organic solvent (A) and the organic solvent (B) can prevent the organic solvent (A) from penetrating a conductive polymer film while maintaining stripping properties for a resist film, thus giving a conductive polymer pattern having little coloration and fine line width.

Such an organic solvent (B) is selected from the group consisting of an alkyrolactone, an alkylene carbonate, and a polyhydric alcohol. With regard to the organic solvent (B), one type thereof may be used on its own or two or more types thereof may be used in combination.

The alkyrolactone is a compound having a cyclic ester bond; examples thereof include a 3-membered lactone (also called an α-lactone), a 4-membered lactone (also called a β-lactone) 5-membered lactone (also called a γ-lactone), and a 6-membered lactone (also called a δ-lactone), and a 5-membered lactone and a 6-membered lactone are preferable.

The alkylene carbonate is an ester compound of an alkylene glycol and a carbonic acid; specific examples of the alkylene carbonate include ethylene carbonate and propylene carbonate, and ethylene carbonate is preferable.

The polyhydric alcohol is an alcohol having two or more hydroxy groups; even if it contains an ether bond, as long as there are two or more hydroxy groups, as in for example diethylene glycol, it corresponds to a polyhydric alcohol. Specific examples of the polyhydric alcohol include ethylene glycol, propylene glycol, diethylene glycol, dipropylene glycol, triethylene glycol, tripropylene glycol, and glycerol. Among them, ethylene glycol, propylene glycol, and diethylene glycol are preferable.

The organic solvent (8) is particularly preferable γ-butyrolactone, ethylene carbonate, ethylene glycol, propylene glycol, or diethylene glycol; among them γ-butyrelactone; propylene glycol, and diethylene glycol are more preferable, and γ-butyrolactone is most preferable.

### <Mixing ratio, etc.>

It is preferable to prepare a stripping liquid by mixing the organic solvent (B) so that, when the width of penetration of the organic solvent (A) on its own into a conductive polymer film is defined as a, the width of penetration of the stripping liquid into the conductive polymer film is no greater than a/2.

By mixing in this way it becomes possible to achieve a balance between stripping properties for a resist film and prevention of swelling, peeling, discoloration, etc. of an edge part.

The width of penetration into a conductive polymer film may be measured by the following test.

A 500 nm thin film is prepared by selecting as a substrate a polyethylene terephthalate (PET) sheet and using CLEVIOS PH500 (product name, containing poly(3,4-ethylenedioxythiophene), manufactured by H.C. Starck) as a conductive polymer on the surface thereof.

Subsequently, it is coated by a spin coater using, as a positive photoresist, TRP-101 (manufactured by Toagosei Co., Ltd.), which is a resist containing a naphthoquinonediazide compound and a novolac resin, and pre-baking at 90°C for 15 minutes, thus forming a resist layer having a film thickness of 1 µm.

This resist layer is exposed to UV light at 100 mJ/cm² via a photo mask having a repeating pattern containing L/S = 10/10 (10 µm line and space) and a square with one side of 400 µm using exposure equipment (manufactured by HI-TECH Co., Ltd.).

It is developed using a developer (aqueous solution with 0.45 wt % KOH and 0.45 wt % K₂CO₃), washed with water, and then dried to thus form a resist pattern.

This substrate is kept within a clean oven at 110°C for 10 minutes, thus carrying out post-baking.

The conductive polymer is subjected to an etching treatment using the patterned resist film as a mask material with an etching liquid that is a mixture of 10 wt % ceric ammonium nitrate and 10 wt % nitric acid at 30°C for 6 sec, and washed with water, thus forming a conductive polymer pattern.

Finally, the resist layer on the conductive polymer film is immersed in organic solvent (A) on its own or a mixed liquid of organic solvent (A) and organic solvent (B) at 12°C for 1 minute to thus strip the resist film, and the mixed liquid is removed from the substrate by means of a dryer (blower outlet air speed of 20 m/s, distance between the dryer blower outlet and the substrate of 100 mm, air speed at the substrate surface of 14 to 18 m/s, room temperature, angle of 45°).

Subsequently, it is immersed in water at 12°C for 1 minute, and water is removed by means of a dryer (blower outlet air speed of 20 m/s, distance between the dryer blower outlet and the substrate of 100 mm, air speed at the substrate surface of 14 to 18 m/s, room temperature, angle of 45°), thus giving a test substrate with a patterned conductive polymer.

This test substrate is examined using a VF-7500 (product name, Keyence Corporation) laser surface profile microscope, and the width of a portion of an edge part of a 10 µm line that becomes white as a result of penetration of the organic solvent (A) or the stripping liquid is measured. The original polythiophene is blue, and the discoloration boundary can be clearly seen.

For the stripping liquid, the proportion of the organic solvent (A) contained is 5 wt % to 40 wt %, and the proportion of the organic solvent (B) contained is 95 wt % to 60 wt °fo. When the proportion of the organic solvent (A) contained is less than 5 wt %, sufficient stripping properties cannot be obtained. When the proportion of the organic solvent (A) contained exceeds 40 wt %, discoloration of an edge part of the conductive polymer film rapidly increases. When the proportion of the organic solvent (B) contained exceeds 95 wt %, sufficient stripping properties cannot be obtained, and when it is less than 60 wt %, discoloration of an edge part of the conductive polymer film rapidly increases.

It is preferable for the content of the organic solvent (A) to be 5 wt % to 20 wt % and for the content of the organic solvent (B) to be 95 wt % to 80 wt %.

In the present invention, the stripping liquid may contain water because pre-stripping washing water becomes attached to the substrate and is brought thereinto or moisture in the air dissolves therein. Since water has no stripping ability and degrades the stripping ability of the mixed liquid, it is preferable to make the water content in the stripping liquid no greater than 10 wt %. It is more preferably no greater than 5 wt %, yet more preferably no greater than 3 wt %, and most preferably no greater than 1 wt %.

In the present invention, in order to strengthen the stripping power the stripping liquid may contain an additive such as a surfactant in an amount that does not adversely affect the conductive polymer. The content thereof is preferable no greater than 5 wt %.

With regard to the surfactant used in the present invention, it is possible to use any of cationic, anionic, nonionic, betaine, etc. types.

### (Conductive polymer)

Examples of the conductive polymer used in the present invention include polyaniline, polythiophene, polypyrrole, polyphenylene, polyfluorene, polybithiophene, polyisothiophene, poly(3,4-ethylenedioxythiophene), polyisothianaphthene, polyisonaphthothiophene, polyacetylene, polydiacetylene, polyparaphenylene vinylene, polyacene, polythiazyl, polyethylene vinylene, polyparaphenylene, polydodecylthiophene, polyphenylene vinylene, polythienylene vinylene, polyphenylene sulfide, derivatives thereof, etc.

Among them, polypyrrole, polyaniline, polythiophene, or a derivative thereof is preferable, polythiophene or a derivative thereof is more preferable, a poly(3,4-dialkoxythiophene) or a derivative thereof is yet more preferable, and a poly(3,4-dialkoxythiophene) is particularly preferable.

Among poly(3,4-dialkoxythiophene)s, poly(3,4-ethylenedioxythiophene), which has excellent electrical conductivity, stability in air, and heat resistance, is most preferable.

In the present invention, a dopant may be used in combination for the purpose of enhancing the conductivity of the conductive polymer. Examples of the dopant include halogens such as iodine and chlorine, Lewis acids such as BF₃ and PF₅, protonic acids such as nitric acid and sulfuric acid, transition metal, alkali metals, amino acids, nucleic acids, surfactants, colorants, chloranil, tetracyanoethylene, and TCNQ, which are well known. As a dopant when a polythiophene and derivatives thereof are used, polystyrenesulfonic acid is preferably used.

When the conductive polymer is applied, it is often used as a liquid containing a binder resin, a surfactant, an antifoaming agent, and a surfactant.

An undercoating may be provided such as one used for strengthening the adhesion between the conductive polymer and the substrate.

In the present invention, the stripping liquid is also effective for prevention of penetration into such a binder resin or undercoating.

Examples of the binder resin includes a polyurethane resin, a polyester resin, polyvinyl alcohol, polyvinylidene chloride, and polyvinyl acetate.

Examples of the polyurethane resin include U710 (manufactured by Alberdingk Boley), Sancure^{™} 825 (manufactured by Lubrizol), NeoRez^{™} R986 (manufactured by DSM), and Bayderm^{™} Finish 85UD (manufactured by LANXESS).

Examples of the polyester resin include Eastek^{™} 1200-02-30% (manufactured by EASTMAN) and Plas Coat Z-465 (manufactured by Goo Chemical Co., Ltd.).

As a specific conductive polymer, a polyaniline sold under the product name 'Panipol' (manufactured by Panipol), which is an organic solvent-voluble polyaniline doped with a functional sulfonic acid, is known.

A polyaniline sold under the product name 'Ormecon' (manufactured by Ormecon) is a solvent-dispersed polyailine employing an organic acid as a dopant.

A poly(3,4-ethylenedioxythiophene) sold under the product name 'CLEVIOS' (manufactured by H.C. Starck) employs polystyrenesulfonic acid as a dopant.

Alternatively, a polypyrrole sold under the product name 'ST-Poly' (manufactured by Achilles Corporation), a sulfonated polyaniline sold under the product name 'PETMAX' (manufactured by Toyobo Co., Ltd.), and a polyaniline sold under the product name 'SCS-NEO' (manufactured by Marual Inc.) may also be used in the present invention.

A conductive polymer described in Kagaku (Chemistry) 6 'Yukidoudensei Porima' (Organic Conductive Polymers) 2001 of a patent licensing support chart as an enterprise for encouraging patent licensing may also be used in the present invention.

### (Substrate)

The substrate used in the present invention may be selected appropriately in accordance with an intended application or purpose.

Specific examples thereof include grasses such as soda-lime glass, silicate glass, barium grass, phosphate glass, borate glass, fluoride glass, and quartz glass, wafers consisted of silicon, germanium, gallium arsenide, gallium arsenide phosphide, gallium nitride, silicon carbide, etc., polyesters such as polyethylene terephthalate and polyethylene naphthalate, polyolefins such as polyethylene, polypropylene, poly(4-methylpentene), and cyclic polyolefins, and others such as polystyrene, polyimide, polyacrylate, and polymethacrylate.

Preferred examples of the substrate include a glass, a wafer, a polyester, and a polyolefin. A polyethylene terephthalate film or sheet, which gives a flexible substrate and makes installation thereof in an image display device easy, is particularly preferably.

### (Resist)

As the resist used in the present invention, either a liquid form or a solid form may be used. A photoresist or a dry film resist is particularly preferable, and a liquid-form photoresist is most preferable.

### (Conductive polymer film pattern)

The smaller the minimum line width of a patterned conductive polymer film, the more a stripping liquid penetrates into the conductive polymer film and the larger the proportion of the area occupied by discolored parts. The stripping liquid used in the present invention exhibits an effect particularly when it is used in such a case.

In general, line width is called Line (designated L), and the gap between line width and line width is called Space (designated S). As described above, the width of discoloration due to penetration into a conductive polymer of an organic solvent for stripping a resist depends on the composition of the organic solvent. When the width of penetration is defined as X (µm), since the smaller the line width L (µm), the larger the effect on the conductive polymer (expressed by effect factor (%) = X/L x 100), if the width X of penetration is the same, the line width employed is important.

The properties of the conductive polymer in a part into which the organic solvent has penetrated are changed from the conductive polymer prior to patterning, and there are various adverse affects when the conductive polymer is put into practical use.

The part into which the organic solvent has penetrated easily peels off from the substrate due to swelling, In the swollen part, a force that attempts to widen it in a direction parallel to the substrate more than before swelling occurs, and adhesion to the substrate is weakened. The smaller the line width, the more the proportion of the part having poor adhesion, and the more easily it is peeled.

Furthermore, the part into which the organic solvent has penetrated is swollen and appears a different color from that before swelling.

Inorganic compound transparent conductive films have a characteristic color. ITO is yellow and a ZnO film is blue; these transparent conductive films are resistant to penetration of an organic solvent, etc., and even if there is penetration the original color remains.

On the other hand, the conductive polymer also has a characteristic color depending on the type; polythiophene is blue, polyaniline is green, and polypyrrole is black, but when the resist film is examined by microscope after stripping, the part into which the organic solvent has penetrated is discolored with a touch of white. Such partial discoloration becomes a problem in an application such as in an LCD pixel electrode in which color is displayed by transmission of light In an LCD pixel electrode, the shadow of a pixel electrode pattern appears on an image display screen. Such a phenomenon is also observed in a touch panel. Furthermore, in an LCD pixel electrode, a discolored part within a pixel electrode displays a different color from the original color that is to be displayed. On the other hand, since a part within the pixel electrode that has not been discolored displays the original color, in such a case, the human eye recognizes it as a different color from the original color to be displayed due to color mixing (a plurality of colors are mixed and are seen as one color that is different from the original colors. Full color display using the three colors of RGB is one example of color mixing), and there is a problem with color reproduction.

Although it depends on the screen dimensions and resolution of a display, the minimum line width of a transparent conductive film when used in a display such as an LCD is in general approximately 2 µm to 500 µm.

Furthermore, the part into which the organic solvent has penetrated has a degraded uniformity of film thickness due to the swelling. As an application in which uniformity of film thickness is important, an organic EL can be cited.

In an organic EL, variation in the thickness of a conductive polymer film causes variation in the film thickness of a light-emitting layer. Electric charge concentrates on a part of the light-emitting layer in which the film thickness is too thin, and the light-emitting layer might be destroyed. The part that has been destroyed does not emit light and becomes a so-called dark spot.

Although it depends on screen dimensions and display resolution, the minimum line width of a transparent conductive film when used in an organic EL is approximately 2 µm to 500 µm.

Therefore, in practice, the minimum line width in patterning of a conductive polymer is no greater than 500 µm. It is preferably no greater than 300 µm, more preferably no greater than 100 µm, yet more preferably no greater than 30 µm, and most preferably no greater than 20 µm.

On the other hand, when the minimum line width becomes smaller, the burden on exposure and a photo mask in photolithography increases, and the exposure equipment and photo masks used become expensive. Therefore, the minimum line width of a pattern of a conductive polymer is preferably at least 2 µm, more preferably at least 4 µm, yet more preferably at least 6 µm, and most preferably at least 10 µm.

### 2. Process for producing substrate having patterned conductive polymers film

The process for producing a substrate of the present invention includes in sequence (A) a step of forming a substrate having in order above the substrate a conductive polymer film and a patterned resist film (hereinafter, also called a substrate formation step or step (A)), a step of etching the conductive polymers film in accordance with the resist film pattern (hereinafter, also called an etching step or step (B)), and a step of stripping the resist film above the conductive polymer film by means of a stripping liquid (hereinafter, also called a stripping step car step (C)).

### (Step (A))

Step (A) is a step of forming a substrate having in order above the substrate a conductive polymer film and a patterned resist film; the step (A) preferably comprises a step of forming a conductive polymer film on a substrate, a step of forming a resist film on/above the conductive polymer film, and a step of patternwise exposing the resist film to UV and developing using a developer, and more preferably comprises the above-mentioned steps in that order.

In the step of forming a conductive polymers film on a substrate, a thin film of the conductive polymer may be formed by coating the substrate with a solution of the conductive polymer and drying, or a thin film may be formed by polymerizing a conductive polymer on the surface of a substrate.

A dopant may be added by a known method. Either a method in which a dopant is added to a solution of the conductive polymer, a dopant is introduced after a conductive polymer film is formed in advance or a method in which a dopant is inserted when preparing a conductive polymer film may be used.

The thin film of the conductive polymer is preferably at least 1 nm but no greater than 10 µm, more preferably at least 5 nm but no greater than 1,000 nm, yet more preferably at least 10 nm but no greater than 500 nm, and particularly preferably at least 10 nm but no greater than 300 nm.

The step of forming a resist film on/above the conductive polymer film so formed preferably involves coating the conductive polymer film with a resist solution and baking to thus form a resist films.

Subsequently, it preferably comprises a step of patternwise exposing the resist film using UV and developing by means of a developer. This resist film is preferably exposed via a mask pattern, thus forming a pattern on the resist film.

Examples of an exposure light source for the resist film include an Ar laser, a semiconductor laser, a He-Ne laser, a YAG laser, and a carbon dioxide laser.

This enables a substrate to be obtained having, in order above the substrate, a conductive polymer and a patterned resist film.

### (Step (B))

Subsequently, in step (B), the conductive polymer film is etched in accordance with the resist film pattern. That is, the conductive polymer is subjected to etching using the patterned resist film as a kind of mask, thus forming a conductive polymer pattern. The method for etching is not particularly limited, and a known method may be used.

In the present invention, as a method for etching the conductive polymer film, a wet etching method employing an etching liquid can be cited as an example, and either an immersion method or a spray method may be used.

Furthermore, the conductive polymer film may be subjected to dry etching. Examples of dry etching include plasma etching, photoetching, and ion beam etching. As plasma etching, reactive ion etching is preferable. Examples of photoetching include UV light etching in which etching is carried out by irradiation with UV, and as the UV, light employing harmonics such as an excimer laser or a YAG laser may be used.

In addition, it is preferable to carry out post-baking after development of the resist.

### (Step (C))

In step (C) (stripping step), the resist film on/above the conductive polymer is stripped by the stripping liquid, thus giving a conductive polymer pattern.

In the stripping step, it is necessary for the substrate after the conductive polymer is subjected to patterning (hereinafter, called a subjected substrate) to make contact with the stripping liquid, Examples of such a stripping step include a method in which a subjected substrate is placed in a container charged with a stripping liquid (dipping method) and a method in which a stripping liquid is sprayed on a subjected substrate (atomizing method, spraying).

In the method in which a subjected substrate is placed in a container, it is preferable to use the stripping liquid so that a resist layer on/above the subjected substrate is completely immersed.

It is necessary to contact the substrate to be treated with a stripping liquid at least until the resist layer is completely separated from the conductive polymer film, and from 10 seconds to 5 minutes as appropriate is usually selected. From 20 seconds to 3 minutes is preferably selected, and more preferably from 30 seconds to 2 minutes.

Since the treatment time may be shortened by also stirring the stripping liquid, other than the above-mentioned spraying, a method involving immersion-shaking, liquid circulation, ultrasonic waves, etc. may be used.

In the stripping step, it is preferable to control the temperature of the stripping liquid.

A stripping liquid is normally used by heating, but a stripping liquid sometimes adversely affects the conductivity of a conductive polymer film in a high temperature treatment. The temperature is therefore preferably no greater than 50°C. It is more preferably no greater than 40°C, yet more preferably no greater than 35°C, and most preferably no greater than 30°C. Since the stripping ability is degraded at low temperature, it is preferably at least 5°C, and more preferably at least 10°C.

It is preferable for there to be a washing step, after the stripping step is completed, of pulling out a subjected substrate and washing with a washing liquid such as water (for example, distilled water) or an organic solvent.

The washing liquid used for washing is preferably water, acetone, a lower alcohol, or a mixture thereof. In the present invention, the lower alcohol is an alcohol having an optionally branched alkyl group having 1 to 4 carbon atoms, and is specifically methanol, ethanol, n-propanol, isopropanol, n-butanol, isobutanol, or tert-butanol. These lower alcohols may be mixed and used, and another alcohol having a relatively low boiling point, such as for example n-hexanol or cyclohexanol, may be mixed in a range that does not degrade the washing properties. A preferred washing liquid is ion-exchanged water, methanol, and/or ethanol, or a mixture thereof. Water is most preferable as the washing liquid.

The time for the washing step in the present invention is preferably 30 sec to 5 min. When the time for the washing step is at least 30 sec, sufficient washing properties can be obtained, and when it is no greater than 5 min, the conductive polymer does not come off the substrate. It is preferable to set the time for the washing step in the above-mentioned range since the yield of substrate having conductive polymer is good.

In the washing step above, it is preferable to control the temperature of the washing liquid. In order to shorten the washing time and prevent washing residue, the washing temperature is preferably at least 5°C, and in order to prevent degradation of conductivity of the conductive polymer after washing, that is, prevent increase in the surface resistance, the washing temperature is preferably no greater than 60°C. The temperature of the washing liquid is preferable at least 5°C but no greater than 50°C, more preferably at least 10°C but no greater than 40°C, and yet more preferably at least 10°C but no greater than 30°C.

In the present invention, it is preferable for at least one of the stripping step and the washing step to be carried out at a temperature of 5°C to 60°C, and it is more preferable for both the stripping step and the washing step to be carried out at a temperature of 5°C to 60°C.

In order to reduce the burden on washing, it is preferable to remove stripping liquid adhering to the substrate before washing. As a method therefor, a known method such as wiping using a cloth, squeezing by sandwiching with a sponge roller, blowing using a gas, or shaking off with centrifugal force by rotating the substrate may be applied.

Adhesion between a conductive polymer film and a substrate is sometimes weak and, in particular, when the conductive polymer film comes into contact with a solid while it is wet with a stripping liquid, the possibility of the conductive polymer film partially coming off or curling sup from the substrate increase. As a method for removing stripping liquid, blowing with a gas is preferable. Examples of the gas include air, nitrogen, oxygen, and an inert gas such as neon or helium, and air is inexpensive and preferable.

It is preferable to apply the gas in a direction oblique to the substrate since it is difficult to carry out removal when the gas is applied perpendicular to the substrate and a conductive polymer is peeled off when it is applied horizontally to the substrate; it is more preferable that the angle in the oblique direction is in the range of 45° ± 30°.

With regard to a method for removing a washing liquid such as water, methanol, acetone, or ethanol from the substrate after washing, it is also preferable to blow a mixed liquid using a gas.

Furthermore, in the present invention, after the washing step it is preferable to carry out a drying step. With regard to the drying step, a known method may be appropriately selected.

The method for stripping a resist film of the present invention is not limited to the above-mentioned case in which a resist film formed directly on a conductive polymer is stripped. It may be applied to a case in which another film is formed on a conductive polymer, a resist is formed thereon, and stripping is carried out after patterning, or a case in which another film is formed on a substrate equipped with a patterned conductive polymer, a resist is further formed thereon, and stripping is carried out after patterning.

A detailed explanation is given below by reference to drawings. In the drawings below, the same reference numerals denote the same objects.

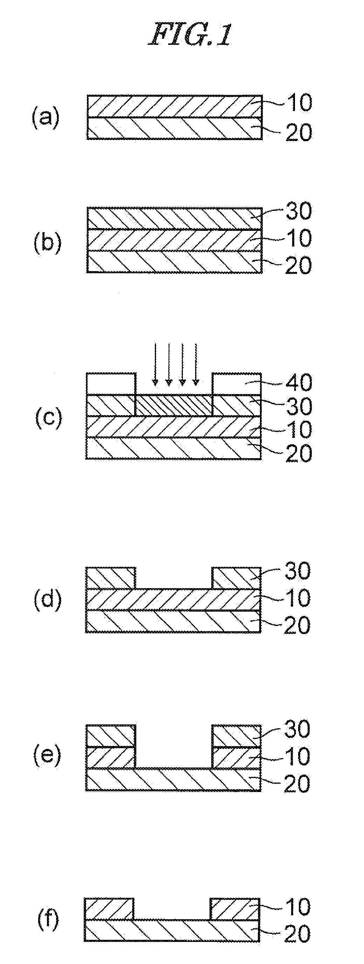

FIG. 1 is a process drawing showing a method for stripping a resist film formed directly on a conductive polymer.

In FIG. 1 (a), a conductive polymer 10 is formed on a substrate 20. Subsequently, a resist film 30 is formed on the conductive polymer 10 (FIG. 1(b)). The resist film 30 is exposed via a mask pattern 40 (FIG. 1 (c)), and developed patternwise (FIG. 1 (d)). In FIG. 1, a positive-working resist is used as the resist film 30, and an exposed portion becomes soluble. The light source used for exposure is not particularly limited, and UV may be suitably used.

Subsequently, the conductive polymer 10 is etched (FIG. 1 (e)) and, furthermore, the resist film 30 on the conductive polymer 10 is stripped (FIG. 1 (f)). The stripping liquid and the stripping method of the present invention may be used suitably as a stripping liquid for the resist film 30 on the conductive polymer 10 shown in FIG. 1 (f) above and as a stripping method for the resist film.

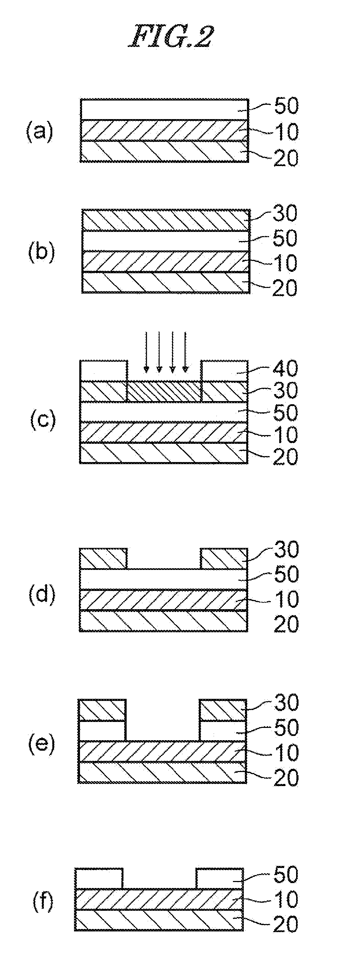

FIG. 2 is a process drawing showing a method for stripping a resist film formed above a conductive polymers via another film.

In FIG. 2 (a), a conductive polymer 10 and another film 50 are formed in order on a substrate 20. Subsequently, a resist film 30 is formed on the other film 50 (FIG. 2 (b)), and in the same manner as for FIG. 1 (c) the resist film 30 is exposed via a mask pattern 40 (FIG. 2 (c)). The resist film 30 is developed patternwise (FIG. 2 (d)), and subsequently the other film 50 is etched (FIG. 2 (e)). Finally, the resist film 30 formed above the conductive polymer 10 via the other film 50 is stripped, and in this stage since the stripping liquid comes into contact with the conductive polymer 10, if the stripping liquid of the present invention is used, it is possible to prevent the conductivity of the conductive polymer 10 from being degraded and the surface resistance from increasing (FIG. 2 (f)).

The stripping liquid and the stripping method of the present invention may also be used as a stripping liquid and a method for stripping a resist film for the resist film 30 provided on the conductive polymer 10 via the other film 50 as shown in FIG. 2 (e).

The other films here is not particularly limited, and examples thereof include wiring mental (aluminum, copper, silver, molybdenum, titanium, tantalum, chromium) for an LCD or an organic EL and an external light reflecting material (silver, etc.) used in a reflection type LCD.

### (Post-baking)

An end part of a conductive polymer film that comes into contact with etching liquid is easily invaded by an organic solvent. In order to reduce parts of a conductive polymer film that come into contact with etching liquid, a method in which adhesion between a resist film and a conductive polymer film is increased to thus prevent an etching liquid from invading a gap between the resist films and the conductive polymer films is effective. Since it is possible to prevent invasion of an organic solvent, into a conductive polymer film by strengthening the adhesion, it is desirable to carry out a treatment that strengthens the adhesion. As a method for increasing the adhesion, there are a method in which pre-baking after coating with a resist is intensified, a method in which a post-baking treatment is carried out after developing a resist, etc. Among them, it is preferable to carry out post-baking. Due to the post-baking it becomes more difficult to strip the resist film, but the stripping liquid of the present invention can be used in such a case.

### Examples

The present invention is explained below by reference to Examples, but the present invention is not limited to these Examples.

### Example -1

As a substrate a polyethylene terephthalate (PET) sheet was selected, and a thin film with a thickness of 500 nm was formed on the surface thereof using CLEVIOS PH500 (product name, containing poly(3,4-ethylenedioxythiophene), manufactured by H.C. Starck) as a conductive polymer.

Subsequently, as a positive-working photoresist, TRP-101 resist containing a naphthoquinonediazido compound and a novolac resin (manufactured by TOAGOSEI CO., LCD.) was applied using a spin coater, prebaking was carried out at 90°C for 15 min, and a 1 µm thick resist layer was formed.

This resist layer was exposed by irradiating with UV light at 100 m/µm² using exposure equipment (manufactured by Hi-Tech Co., Ltd.) via a photomask having a repeating pattern that included L/S = 10/10 (10 µm line and space) and a square with one side of 400 µm.

A resist pattern was formed by developing using a developer (aqueous solution with 0.45 wt % KOH and 0.45 wt % K₂CO₃), washing with water, and then drying.

This substrate was held within a clean oven at 110°C for 10 minutes, thus carrying out post-baking.

The conductive polymer was subjected to etching using the patterned resist layer as a mask using an etching liquid mixture of 10 wt % ceric ammonium nitrate and 10 wt % nitric acid at 30°C for 6 seconds, and washing with water, thus forming a conductive polymer pattern.

Finally, the resist film was stripped by immersing the resist layer above the conductive polymer film at 12°C for 1 minute using as a stripping liquid a mixed liquid of 5% of *N*-methylpyrrolidone as organic solvent (A) and 95% of γ-butyrolactone as organic solvent (B), and the mixed liquid was removed from the substrate using a dryer (blower outlet air speed 20 m/s, distance between dryer blower outlet and substrate 100 mm, substrate surface air speed 14 to 18 m/s, room temperature, angle 45°).

Subsequently, it was immersed in water at 12°C for 1 minute, and water was removed using a dryer (blower outlet air speed 20 m/s, distance between dryer blower outlet and substrate 100 mm, substrate surface air speed 14 to 18 m/s, room temperature, angle 45°), thus giving a test substrate having a patterned conductive polymer.

The following tests were carrying out using the test substrate.

### Examination of end part of conductive polymer

A test substrate was examined using a VF-7500 (product name, manufactured by Keyence Corporation) laser type surface profile microscope, and the width of a part that became white due to the mixed liquid penetrating into an end part of a 10 µm line was measured. The original polythiophene was blue, and the discoloration border could be clearly seen.

The penetration width is in practice preferably no greater than 0.9 µm, more preferably no greater than 0.7 µm, and yet more preferably no greater than 0.3 µm.

Furthermore, the effect factor (%) was obtained by dividing the penetration width by the line width. The effect factor is in practice preferable no greater than 9%, more preferably no greater than 7%, and yet more preferably no greater than 3%.

### Stripping properties (resist residue)

A dried test substrate was examined using a VF-7500 (product name, manufactured by Keyence Corporation) laser type surface profile microscope, and the presence or absence of resist film remaining on the conductive polymer film without being stripped was determined.

Examination was carried out for a part corresponding to one repeating pattern present in a photo mask. This one pattern corresponded to a range of about 3 mm x about 3 mm.

### Evaluation criteria:

Good: there was no unstripped resist.
Fair: there was unstripped resist smaller than 1 µm.
Poor: there was unstrapped resist of 1 µm or greater.

From the results, it was found that a part that became white by the mixed liquid penetrating into an end part of the conductive polymer was less than 0.3 µm, and no resist remained without being stripped. These results are given in Table 1.

### Examples 1-2 to 1-8

Tests were carried out by the same methods as in Example 1-1 except that the stripping liquid was changed to those shown in Table 1. The results are given in Table 1.

### Comparative Examples 1-1 to 1-4

Tests were carried out by the same methods as in Example 1-1 except that the organic solvent was changed to those shown in Table 1. The results are given in Table 1.

**Table 1**

| | Stripping liquid | | Evaluation | | |
|---|---|---|---|---|---|
| | Organic solvent: (A) | Organic solvent (B) | Width of discolored part | Effect factor | Resist residue |
| | *N*-methyl pyrrolidone | γ-Butyrolactone | | | |
| | wt% | wt % | µm | % | |
| Ex. 1-1 | 5 | 95 | < 0.3 | < 3 | Good |
| Ex. 1-2 | 10 | 90 | <0.3 | < 3 | Good |
| Ex. 1-3 | 15 | 85 | < 0.3 | < 3 | Good |
| Ex. 1-4 | 20 | 80 | <0.3 | < 3 | Good |
| Ex. 1-5 | 25 | 75 | 0.5 | 5 | Good |
| Ex. 1-6 | 30 | 70 | 0.5 | 5 | Good |
| Ex. 1-7 | 35 | 65 | 0.5 | 5 | Good |
| Ex. 1-8 | 40 | 60 | 0.5 | 5 | Good |
| Comp. Ex. 1-1 | 100 | 0 | 2.0 | 20 | Good |
| Comp. Ex. 1-2 | 0 | 100 | <0.3 | < 3 | Poor |
| Comp. Ex 1-3 | 50 | 50 | 1.0 | 10 | Good |
| Comp. Ex. 1-4 | 3 | 97 | < 0.3 | < 3 | Fair |

### Examples 2-1 to 2-5

Tests were carried out by the same methods as in Example 1-1 except that the stripping liquid was changed to those shown in Table 2. The results are given in Table 2.

### Comparative Examples 2-1 to 2-4

Tests were carried out by the same methods as in Example 1-1 except that the stripping liquid was changed to those shown in Table 2. The results are given in Table 2.

**Table 2**

| | Stripping liquid | | | | Evaluation | | |
|---|---|---|---|---|---|---|---|
| | Organic solvent (A) | | Organic solvent (B) | | Width of discolored part | Effect factor | Resist residue |
| | Component | wt % | Component | wt % | µm | % | |
| Ex. 2-1 | Diethylene glycol monoethyl ether | 40 | γ-Butyrolactone | 60 | 0.6 | 6 | Good |
| Ex. 2-2 | Tetrahydrofuran | 40 | γ-Butyrolactone | 60 | 0.6 | 6 | Good |
| Ex. 2-3 | *N,N*-Dimethym formamide | 5 | γ-Butyrolactone | 95 | 0.3 | 3 | Good |
| Comp. Ex.2-1 | Diethylene glycol monoethyl ether | 100 | - | 0 | 2.1 | 21 | Good |
| Comp. Ex. 2-2 | Tetrahydrofuran | 100 | - | 0 | 3.3 | 33 | Good |
| Comp. Ex. 2-3 | Diethylene glycol monoethyl ether | 50 | γ-Butyrolactone | 50 | 1.4 | 14 | Good |
| Comp. Ex. 2-4 | Tetrahydrofuran | 50 | γ-Butyrolactone | 50 | 1.6 | 16 | Good |

### Examples 3-1 to 3-2

Tests were carried out by the same methods as in Example 1-1 except that the stripping liquid was changed to those shown in Table 3. The results are given in Table 3.

### Comparative Examples 3-1 to 3-4

Tests were carried out by the same methods as in Example 1-1 except that the stripping liquid was changed to those shown in Table 3. The results are given in Table 3.

**Table 3**

| | Stripping liquid | | | | Evacuation | | |
|---|---|---|---|---|---|---|---|
| | Organic solvent (A) | | Organic solvent (B) | | Width of discolored part | Effect factor | Resist residue |
| | Component | wt % | Component | wt % | µm | % | |
| Ex. 3-1 | *N,N*-Dimethyl acetamide | 40 | Diethylene glycol | 60 | 0.6 | 6 | Good |
| Ex. 3-2 | *N,N*-Dimethyl acetamide | 5 | Diethylene glycol | 95 | < 0.3 | <3 | Good |
| Comp. Ex. 3-1 | *N,N*-Dimethyl acetamide | 100 | Diethylene glycol | 0 | 2.0 | 20 | Good |
| Comp. Ex. 3-2 | *N,N*-Dimethyl acetamide | 0 | Diethylene glycol | 100 | <0.3 | <3 | Poor |
| Comp. Ex. 3-3 | *N,N*-Dimethyl acetamide | 50 | Diethylene glycol | 50 | 1.3 | 13 | Good |
| Comp. Ex. 3-4 | *N,N*-Dimethyl acetamide | 3 | Diethylene glycol | 97 | < 0.3 | < 3 | Fair |

### Example 4-1

Test was carried out by the same methods as in Example 1-1 except that the stripping liquid was changed to that shown in Table 4. The results are given in Table 4.

**Table 4**

| | Stripping liquid | | | | Evaluation | | |
|---|---|---|---|---|---|---|---|
| | Organic solvent (A) | | Organic solvent (B) | | Width of discolored part | Effect factor | Resist residue |
| | Component | wt % | Component | wt % | µm | % | |
| Ex. 4-1 | *N,N*-Dimethyl acetamide | 15 | γ-Butyrolactone Propylene glycol | 45 40 | <0.3 | <3 | Good |

### Industrial Applicability

With regard to a conductive polymer film that is patterned in accordance with the process of the present invention, discoloration of an end part can be suppressed, and a uniform film thickness is formed. The present invention greatly improves the convenience of a conductive polymer as a transparent conductive film, and use of a substrate having a conductive polymer film that is patterned in accordance with the present invention contributes to improvement of performance as an image display device such as a display.

## Claims

1. A process for producing a substrate having a patterned conductive polymer film, comprising in sequence:
a step of forming a substrate having in order above the substrate a conductive polymer film and a patterned resist film;
a step of etching the conductive polymer film in accordance with the resist film pattern; and
a step of stripping the resist film above the conductive polymer film by means of a stripping liquid;
the stripping liquid comprising an organic solvent (A) and an organic solvent (B),
the organic solvent (A) being selected from the group consisting of an *N*-alkylpyrrolidone, a carboxylic acid amide compound, a dialkyl sulfoxide, and an ether compound,
the organic solvent (B) being selected from the group consisting of an alkyrolactone, an alkylene carbonate, and a polyhydric alcohol,
the organic solvent (A) having a content of at least 5 wt % but no greater than 40 wt % of the stripping liquid, and the organic solvent (B) having a content of at least 60 wt % but no greater than 95 wt % of the stripping liquid.

2. The process for producing a substrate according to Claim 1, wherein the organic solvent (A) is selected from the group consisting of *N-*methylpyrrolidone, *N,N*-dimethylformamide, *N,N*-dimethylacetamide, diethylene glycol monomethyl ether, and tetrahydrofuran.

3. The process for producing a substrate according to Claim 1 or 2, wherein the organic solvent (B) is γ-butyrolactone.

4. The process for producing a substrate according to any one of Claims 1 to 3, wherein when the width of penetration of the organic solvent (A) on its own into the conductive polymer film is defined as a, the width of
penetration of the stripping liquid into the conductive polymer film is no greater than a/2.

5. The process for producing a substrate according to any one of Claims 1 to 4, wherein the conductive polymer is selected from the group consisting of polypyrrole, polyaniline, polythiophene, and derivatives thereof.

6. The process for producing a substrate according to any one of Claims 1 to 5, wherein the conductive polymer is a poly(3,4-dialkoxythiophene) or a derivative thereof.

7. The process for producing a substrate according to any one of Claims 1 to 6, wherein the conductive polymer is a poly(3,4-dialkoxythiophene).

8. The process for producing a substrate according to any one of Claims 1 to 7, wherein the substrate is selected from the group consisting of a glass, a wafer, a polyester, and a polyolefin.

9. A substrate comprising a patterned conductive polymer film obtained by the process according to any one of Claims to 8.
